# FASCICULE DE BREVET EUROPEEN

(11) **EP 3 623 827 B1**
(45) Date de publication et mention de la délivrance du brevet: **20.12.2023**
(21) Numéro de dépôt: 19196249.7
(22) Date de dépôt: 09.09.2019
(51) Int. Cl.: G01R 31/317, G01R 31/28, G11C 29/12

(54) **PUCE ÉLECTRONIQUE À ENTRÉES/SORTIES ANALOGIQUES COMPRENANT DES MOYENS D'AUTO-DIAGNOSTIC**
ELEKTRONISCHER CHIP MIT ANALOGEN EINGÄNGEN/AUSGÄNGEN MIT SELBSTTESTMITTELN
ELECTRONIC CHIP WITH ANALOG INPUTS/OUTPUTS COMPRISING SELF-TEST MEANS

(30) Priorité: 12.09.2018 FR 1858150
(43) Date de publication de la demande: 18.03.2020
(73) Titulaire: STMicroelectronics (Grenoble 2) SAS, 38000 Grenoble (FR)
(72) Inventeur: DUCREY, Stéphane, 38500 VOIRON (FR); RAGA, Pascal, 38330 ST ISMIER (FR)
(74) Mandataire: Cabinet Beaumont

(56) Documents cités:
- JP-A- H0 462 642
- JP-A- 2000 315 771
- JP-A- 2008 286 699
- US-A1- 2001 033 583
- US-A1- 2011 109 321
- US-A1- 2011 156 738

## Description

### Domaine technique

La présente description concerne de façon générale les circuits électroniques, et en particulier une puce électronique de circuit intégré conçue pour générer et/ou recevoir des signaux analogiques.

### Technique antérieure

Certaines puces électroniques de circuit intégré comprennent des circuits analogiques. Généralement, des signaux analogiques générés et/ou reçus par ces circuits sortent et entrent dans la puce respectivement par des sorties et entrées analogiques. Le document JP H0462642 divulgue un microprocesseur. Les documents US 2011/109321 et JP 2008 286699 divulguent des appareils de tests de dispositifs électroniques. Les documents JP 2000 315771 et US 2011/156738 divulguent des circuits intégrés.

Le document US 2001/0033583 décrit une passerelle audio avec synchronisation audio descendante.

### Résumé de l'invention

La présente demande a pour objet la mise en oeuvre de dispositifs et procédés alternatifs à ceux connus de l'art antérieur.

Un mode de réalisation prévoit une puce électronique telle que définie dans les revendications 1-5 et un mode de réalisation prévoit un procédé de conception d'une telle puce tel que défini dans les revendications 6-8.

Un mode de réalisation prévoit un procédé d'autodiagnostic d'une puce électronique tel que défini dans les revendications 9-11.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de manière schématique un mode de réalisation d'une puce électronique à entrées/sorties analogiques ;
la figure 2 représente de manière schématique un autre mode de réalisation d'une puce électronique à entrées/sorties analogiques ; et
la figure 3 représente de manière schématique un autre mode de réalisation d'une puce électronique à entrées/sorties analogiques.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits numériques d'une puce électronique à entrées/sorties analogiques ne sont pas représentés en détail, les modes de réalisation décrits étant compatibles avec les puces électroniques usuelles à entrées/sorties analogiques. En outre, les boîtiers de circuit intégré ne sont pas représentés, les modes de réalisation décrits étant compatibles avec les boîtiers usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Divers exemples de mise en oeuvre et de réalisation sont exposés par la suite. Indépendamment de la dénomination donnée à ces exemples (modes de réalisation, exemples, variantes, etc.) et des qualificatifs employés (par exemple, de préférence, etc.), seules les parties de description incluses dans la portée des revendications font partie de la présente invention, les autres exemples n'étant exposés qu'à titre illustratif et n'étant utiles que pour mettre en évidence des aspects spécifiques à l'invention par rapport à ce qui n'en fait pas partie.

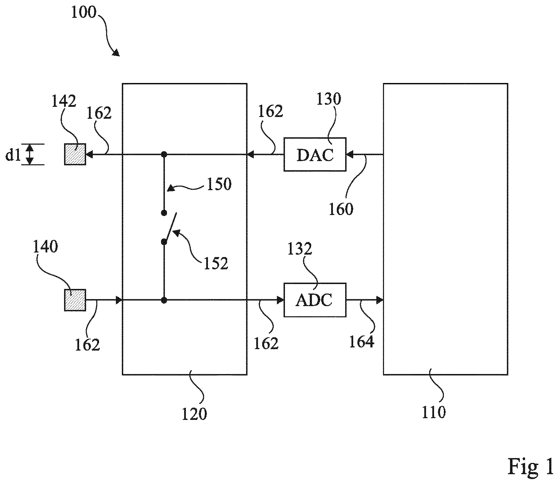

La figure 1 représente de manière schématique un mode de réalisation d'une puce électronique 100 à entrées/sorties analogiques.

La puce 100 comprend typiquement une tranche semiconductrice, non représentée, et des circuits formés dans et sur la tranche. La puce 100 est de préférence une puce de type système sur puce SOC ("System On Chip"). Des puces de type SOC sont utilisées notamment dans des applications embarquées ou mobiles, telles que la téléphonie mobile, les objets connectés, l'électroménager ou le transport. De préférence, la puce 100 est destinée à être disposée dans un boîtier de circuit intégré (non représenté). Le boîtier est de préférence destiné à être connecté, par exemple soudé ou brasé, à un dispositif électronique extérieur tel qu'un circuit imprimé de type PCB ("Printed Circuit Board").

La puce 100 comprend un circuit numérique 110. Le circuit 110 comprend typiquement au moins une unité de traitement séquentiel de données par exemple de type microprocesseur, et divers périphériques tels que des mémoires et/ou des interfaces de communication numérique avec l'extérieur de la puce.

Le circuit 110, et en particulier le microprocesseur, communique avec un circuit analogique 120 de la puce, de préférence au travers de circuits d'interface numérique-analogique. Les circuits d'interface numérique-analogique sont typiquement de type convertisseur numérique-analogique DAC 130 ("Digital-Analog Converter") ou convertisseur analogique-numérique ADC 132 ("Analog-Digital Converter"). Deux circuits DAC et ADC sont représentés à titre d'exemple, mais la puce peut comprendre plus de deux circuits d'interface numérique-analogique, par exemple plusieurs circuits de type DAC et/ou plusieurs circuits de type ADC. En outre, les circuits d'interface numérique-analogique de la puce peuvent être de tout type, éventuellement autre que DAC ou ADC. La puce peut comprendre par exemple un circuit d'interface numérique-analogique tel qu'un comparateur, qui fournit un signal numérique à partir d'un signal analogique.

Le circuit analogique 120 est relié à des plots de connexion 140 et 142. A titre d'exemple, on a représenté en figure 1 un seul plot de sortie 142, et un seul plot d'entrée 140. Cependant, la puce comprend de préférence plus de deux plots de connexion d'entrée 140, et la puce comprend de préférence plus de deux plots de connexion de sortie 142. Les plots de connexion 140, 142 sont typiquement formés de zones conductrices, par exemple des zones métalliques, situées sur une face de la puce 100. Ces zones ont par exemple une même forme rectangulaire ou carrée. Ces zones ont de préférence une longueur de côté d1 comprise entre 50 µm et 150 µm. Les plots de connexion sont connectables à des circuits extérieurs à la puce, de préférence au boîtier dans lequel la puce est destinée à être disposée. Les plots sont de préférence connectables par soudage ou brasage, par exemple à des broches du boîtier. Ces broches sont destinées à être soudées ou brasées à un dispositif extérieur au boîtier.

Les plots 140 sont des plots d'entrée analogique et les plots 142 sont des plots de sortie analogique, c'est-à-dire respectivement d'entrée de signaux analogiques et de sortie de signaux analogiques. On appelle ici signal analogique un signal électrique représentant une information et ayant une valeur variant continûment lorsque l'information représentée varie continûment. De préférence, le signal est susceptible de prendre n'importe quelle valeur dans une plage continue de valeurs. De préférence, le signal n'est pas susceptible de prendre des valeurs en dehors de cette plage. La valeur du signal est de préférence une valeur de tension ou de courant.

La valeur de tension correspond de préférence au potentiel du plot d'entrée ou de sortie concerné, référencé à un potentiel de référence, par exemple la masse. A titre de variante, le signal correspond à la différence entre les potentiels de deux plots d'entrée du signal, ou de deux plots de sortie du signal.

A titre d'exemple, le signal analogique a une plage de valeurs de tension de préférence incluse dans la plage de 0 V à 5 V, par exemple incluse dans la plage de 0 V à 3,6 V. Dans un autre exemple, le signal analogique a une plage de valeurs de courant par exemple incluse dans la plage de -10 mA à 10 mA. En utilisation, les signaux analogiques entrant proviennent typiquement de capteurs extérieurs à la puce. Les signaux analogiques sortant sont typiquement utilisés par des actionneurs extérieurs à la puce.

Dans les présents modes de réalisation, la puce comprend une liaison 150 entre les plots de sortie 142 et d'entrée 140. La liaison 150 comprend un interrupteur 152. En variante, la liaison 150 comprend plusieurs interrupteurs en série, par exemple deux interrupteurs ou plus. De préférence, les interrupteurs comprennent, ou sont constitués par, des transistors. Les transistors sont par exemple des transistors à effet de champ tels que des transistors MOS, ou par exemple des transistors bipolaires.

En fonctionnement, lorsque l'interrupteur 152 est fermé, ou passant, la liaison 150 est active, c'est-à-dire transmet à l'un des plots qu'elle relie, par exemple le plot 142, tout signal appliqué à l'autre des plots, par exemple le plot 140. Lorsque l'interrupteur 152 est ouvert, ou bloqué, la liaison 150 est inactive. Ainsi la liaison 150 peut être activée temporairement en fermant, puis ouvrant l'interrupteur 152. A titre de variante, la puce peut comprendre d'autres liaisons 150 activables temporairement entre des plots d'entrée et de sortie analogiques.

De préférence, le plot de sortie 142 est relié, par exemple connecté, à une sortie du circuit DAC 130. De préférence, le plot d'entrée 140 est relié, par exemple connecté, à une entrée du circuit ADC 132.

De préférence, on prévoit une phase d'autodiagnostic BIST ("Built In Self Test") de la puce. Au cours de cette phase, le circuit numérique 110 vérifie en particulier le bon fonctionnement du circuit analogique 120 et des circuits d'interface numérique-analogique 130 et 132. De préférence, la liaison 150 est active pendant au moins une partie de la phase d'autodiagnostic.

Lorsque la liaison 150 est active, le circuit numérique 110 de la puce envoie une valeur numérique 160 au circuit DAC 130. Le circuit DAC 130 génère un signal analogique 162 en fonction de la valeur numérique 160. Le signal 162 est appliqué au plot 142. La liaison 150 applique alors le signal 162 au plot 140. Le signal 162 est reçu par le circuit ADC 132. Le circuit ADC 132 convertit ce signal en une valeur numérique 164. La valeur numérique 164 est reçue par le circuit numérique 110. Le circuit numérique 110 vérifie alors que la valeur numérique 164 reçue est celle que l'on s'attend à obtenir pour un fonctionnement correct des circuits 130 et 132. L'activation de la liaison 150 permet ainsi de tester simultanément les circuits 130 et 132.

On teste ainsi le fonctionnement du circuit DAC 130 sans mesurer le signal 162 appliqué au plot 142 par un dispositif extérieur à la puce. On teste en outre le fonctionnement du circuit ADC 132 sans appliquer au plot 140 de signal généré par un dispositif extérieur à la puce. Le test de la puce est donc simplifié. En outre, on n'a utilisé aucun des plots de connexion de la puce pour tester les circuits 130 et 132, et on a ainsi réduit le nombre de plots de connexion analogiques et/ou numériques utilisés pour tester l'ensemble des circuits de la puce.

De préférence, une même puce permet de réaliser plusieurs fonctions correspondant à plusieurs applications. Ainsi, plusieurs puces identiques sont destinées à être disposées dans des boîtiers différents de circuit intégré. Ceci permet de choisir le boîtier en fonction d'une application visée. On prévoit de préférence que certains des plots de connexion 140, 142 soient connectés ou reliés à une broche du boîtier pour certaines applications et ne soient reliés à aucune broche pour d'autres applications. On prévoit ainsi, pour une même puce, des boîtiers ayant des nombres de broches différents. La liaison 150 permet alors de tester le fonctionnement des circuits DAC 130 et ADC 132 lorsque la puce est située dans un boîtier et que le ou les plots 140 et/ou 142 ne sont pas connectés.

En outre, le signal 162 parvenant au circuit ADC 132 diagnostiqué peut avoir un parcours plus court et moins exposé à des perturbations, par exemple électromagnétiques, qu'un signal généré par un dispositif extérieur à la puce. La précision du diagnostic est donc améliorée par rapport à celle d'un diagnostic utilisant un dispositif extérieur à la puce.

De préférence, la liaison 150 est toujours inactive en dehors de la phase d'autodiagnostic. Notamment, la liaison 150 reste de préférence inactive pendant une phase d'utilisation de la puce. Ceci permet d'utiliser les circuits DAC 130 et ADC 132 indépendamment l'un de l'autre, c'est-à-dire que les circuits DAC 130 et ADC 132 peuvent générer et recevoir des signaux analogiques différents, utilisés par et en provenance de dispositifs extérieurs à la puce.

A titre de variante, on peut remplacer le circuit DAC 130 par tout autre circuit générateur de signaux analogiques, tel que par exemple un amplificateur ou un générateur de tension de référence. On peut remplacer le circuit ADC 132 par tout autre circuit récepteur de signaux analogiques, comprenant par exemple un amplificateur ou un comparateur. Grâce à la liaison 150, le générateur et le récepteur peuvent être testés simultanément au cours de la phase d'autodiagnostic, et peuvent être utilisés indépendamment l'un de l'autre au cours de la phase d'utilisation. De préférence, la puce comporte plusieurs liaisons 150 reliant des plots de sortie de plusieurs générateurs de signaux analogiques à des plots d'entrée d'un ou de plusieurs récepteurs de signaux analogiques. Chaque liaison 150 permet alors de tester simultanément un générateur et un récepteur au cours de l'autodiagnostic.

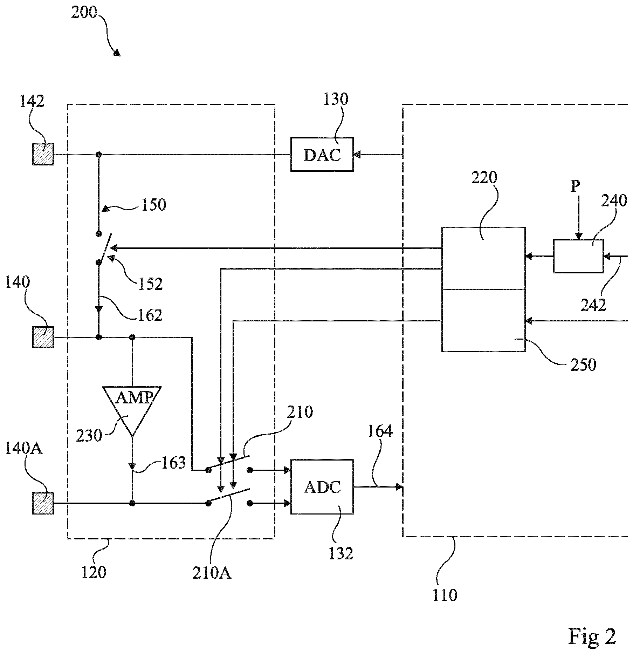

La figure 2 représente de manière schématique un mode de réalisation d'une puce électronique 200 à entrées/sorties analogiques. La puce 200 comprend les éléments de la puce 100 de la figure 1, reliés entre eux de manière identique ou similaire, à la différence que le plot 140 est relié au circuit ADC 132 par un interrupteur 210. La puce comprend en outre un plot 140A de connexion d'entrée analogique relié par un interrupteur 210A au circuit ADC 132. Les interrupteurs 210 et 210A sont de préférence reliés chacun à un canal d'entrée distinct du circuit ADC 132. De préférence, les interrupteurs 210 et 210A sont activables pendant la phase d'autodiagnostic. De préférence, la puce comprend en outre un amplificateur 230 (AMP) entre les plots 140 et 140A. Dans cette configuration, à titre d'exemple, le plot 140A est en outre un plot de connexion de sortie analogique.

De préférence, la puce comprend en outre des emplacements mémoire 220 stockant des niveaux logiques de commande des interrupteurs 150, 210 et 210A pendant la phase d'autodiagnostic. Les emplacements mémoire 220 sont de préférence situés dans une mémoire non volatile réinscriptible comprise dans le circuit numérique 110 de la puce. On peut ainsi sélectionner, parmi les interrupteurs 152, 210 et/ou 210A, ceux qui sont fermés pendant la phase d'autodiagnostic. Pour cela, on écrit les niveaux logiques correspondants dans les emplacements mémoire 220.

En phase d'autodiagnostic, lorsque l'interrupteur 210 est fermé, l'autodiagnostic est réalisé de la manière décrite en relation avec la figure 1. Lorsque l'interrupteur 210A est fermé, le signal 162 qui parvient au plot 140 est amplifié par l'amplificateur 230. L'amplificateur 230 fournit un signal 163. Le signal 163 est reçu par le circuit ADC 132, qui fournit le signal 164 au circuit numérique 110. On teste ainsi simultanément le fonctionnement des circuits DAC 130, ADC 132, et de l'amplificateur 230. En sélectionnant celui des interrupteurs 210 et 210A qui est fermé au cours de la phase d'autodiagnostic, on choisit entre tester et ne pas tester l'amplificateur 230 en même temps que les circuits 130 et 132.

Dans le cas où la puce comprend plusieurs générateurs de signaux analogiques et/ou plusieurs récepteurs de signaux analogiques, plusieurs liaisons 150 comprenant des interrupteurs 152 relient les générateurs aux récepteurs. En phase d'autodiagnostic, ces interrupteurs sont commandés en fonction des contenus des emplacements mémoire 220. Ceci permet de sélectionner, pour chacun des générateurs, un ou plusieurs des récepteurs pour recevoir un ou des signaux émis par le générateur en phase d'autodiagnostic. Ceci permet de sélectionner, pour chacun des récepteurs, un ou plusieurs des générateurs pour générer un ou des signaux reçus par le récepteur en phase d'autodiagnostic.

De préférence, la puce comprend plusieurs circuits de réception et génération de signaux analogiques tels que l'amplificateur 230. Chacun de ces circuits peut avoir son entrée et sa sortie reliés par des interrupteurs 210 et 210A à un récepteur de signaux analogiques tel que le circuit ADC 132. En phase d'autodiagnostic, ces interrupteurs sont commandés en fonction des contenus des emplacements mémoire 220. Ceci permet, pour chaque signal analogique émis en phase d'autodiagnostic, de choisir d'amplifier ou non ce signal, et éventuellement de sélectionner un des amplificateurs pour cette amplification.

De préférence, on prévoit que l'écriture dans les emplacements mémoire 220 soit protégée par un mot de passe. De préférence, un circuit 240 est configuré pour écrire des niveaux logiques 242 dans les emplacements mémoire 220 seulement si un mot de passe P a été fourni au circuit 240. Le circuit 240 est de préférence compris dans le circuit numérique 110 de la puce. A titre d'exemple, le circuit 240 est un microprocesseur configuré pour exécuter un programme de protection par le mot de passe. Ainsi, seul un utilisateur connaissant le mot de passe peut sélectionner parmi les interrupteurs ceux qui sont fermés pendant la phase d'autodiagnostic.

De préférence, en phase d'utilisation de la puce, les interrupteurs 210 et 210A sont commandés par des signaux logiques dont les niveaux sont stockés dans des emplacements mémoire 250. Les emplacements mémoire 250 sont de préférence non volatiles et réinscriptibles. On peut ainsi sélectionner parmi les interrupteurs 210 et/ou 210A ceux qui sont fermés pendant la phase d'utilisation. Pour cela, on écrit préalablement les contenus correspondants dans les emplacements mémoire 250. Dans l'exemple représenté, lorsque l'on souhaite convertir un signal analogique par le circuit ADC 132, on peut choisir ou non d'amplifier le signal par l'amplificateur 230 avant conversion.

De préférence, la puce comprend plusieurs interrupteurs reliant les plots d'entrée/sortie de la puce à plusieurs circuits générateurs et/ou récepteurs de signaux analogiques. L'état de ces interrupteurs est alors commandé par les contenus des emplacements mémoire 250. Les circuits analogiques de la puce peuvent alors être reconfigurés en modifiant le contenu des emplacements mémoire 250. Un utilisateur peut choisir ces contenus pour que la puce réalise des fonctions souhaitées en fonction d'une application visée. Une même puce peut ainsi réaliser diverses fonctions pour diverses applications visées.

Les niveaux de commande des interrupteurs appliqués en phase d'autodiagnostic et en phase d'utilisation peuvent être différents, du fait que ces niveaux sont stockés dans les emplacements respectifs 220 et 250. On peut choisir les tests effectués pendant la phase d'autodiagnostic, indépendamment des fonctions réalisées pendant la phase d'utilisation. Ceci permet d'effectuer un autodiagnostic plus complet que pour une puce dans laquelle seules les fonctions réalisées pendant la phase d'utilisation peuvent être autodiagnostiquées.

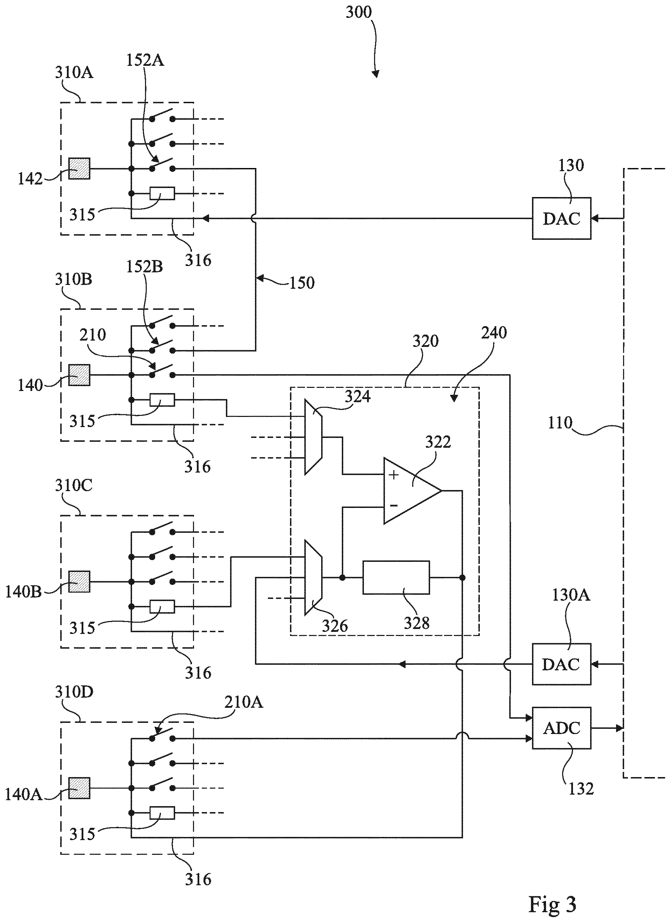

La figure 3 représente de manière schématique un autre mode de réalisation d'une puce électronique 300 à entrées/sorties analogiques. La puce 300 comprend les éléments de la puce 200 de la figure 2, reliés entre eux de manière identique ou similaire. La liaison 150 comprend ici deux interrupteurs 152A et 152B connectés en série entre les plots 142 et 140. Les niveaux de commande des interrupteurs 152A et 152B sont de préférence stockés dans les emplacements mémoire 220 (figure 2). A titre d'exemple, la puce comprend en outre un plot de connexion d'entrée supplémentaire 140B relié à l'amplificateur 240.

Pour concevoir la puce électronique 300, on met en oeuvre par ordinateur un procédé de conception. Un procédé de conception par ordinateur d'une puce de circuit intégré utilise typiquement une bibliothèque de blocs de conception. Chaque bloc définit un ensemble d'éléments des circuits de la puce et de connexions entre ces éléments. Lors de la conception, on définit des connexions entre les blocs. Les connexions et les blocs ainsi obtenus sont compatibles avec les techniques de routage usuelles, permettant de définir ensuite l'agencement dans la puce des éléments et de pistes connectant ces éléments.

Chaque plot de connexion 142, 140, 140B, 140A de la puce 300 est compris dans un bloc de conception, respectivement 310A, 310B, 310C, 310D. Chaque bloc de conception comprend, outre le plot de connexion, un ou plusieurs, de préférence trois, interrupteurs reliés, de préférence connectés, au plot de connexion. De préférence, chaque bloc de conception comprend en outre un élément résistif 315 relié, par exemple connecté, au plot de connexion. De préférence, chaque bloc de conception comprend en outre une connexion directe 316 au plot de connexion.

De préférence, certains des blocs de conception sont identiques. Dans l'exemple illustré, les quatre blocs sont identiques. L'interrupteur 152A est l'un des interrupteurs du bloc 310A, et l'interrupteur 152B est l'un des interrupteurs du bloc 310B. Chaque interrupteur 152A, 152B est ainsi associé au plot respectif 140, 142 dans un des blocs de conception. A titre d'exemple, l'interrupteur 210 est l'un des interrupteurs du bloc 310B. L'interrupteur 210A est l'un des interrupteurs du bloc 310D.

De préférence, l'amplificateur 240 est défini par un bloc de conception 320. Ce bloc comprend de préférence un amplificateur opérationnel 322, un multiplexeur 324 dont la sortie est reliée à l'entrée non inverseuse de l'amplificateur 322, un multiplexeur 326 dont la sortie est reliée à l'entrée inverseuse de l'amplificateur 322, et un circuit 328 de rétroaction reliant l'entrée inverseuse et la sortie de l'amplificateur 322. De préférence, on définit des connexions des résistances 315 des blocs 310B et 310C aux entrées des multiplexeurs respectifs 324 et 326.

On prévoit par exemple un circuit DAC 130A reliant le circuit numérique 110 à une entrée du multiplexeur 326. De préférence, les circuits DAC 130 et 130A correspondent à des blocs de conception, par exemple identiques. Le circuit ADC 132 correspond de préférence à un bloc de conception.

Pour concevoir la liaison 150, il suffit de définir une connexion entre les interrupteurs 152A et 152B. Ainsi, la conception de la puce 300 est faite de manière particulièrement simple à partir de celle d'une puce similaire ne comprenant pas de liaison 150.

Dans la puce ainsi conçue, on prévoit de préférence que des valeurs de commande des multiplexeurs 324 et 326, et des paramètres de configuration du circuit de rétroaction 328, soient stockés dans les emplacements mémoire 220 (figure 2). On peut ainsi sélectionner la provenance des signaux appliqués aux entrées de l'amplificateur 322 en phase d'autodiagnostic. On peut en outre sélectionner les paramètres de configuration du circuit de rétroaction 328 en phase d'autodiagnostic.

De préférence, on prévoit que des valeurs de commande des multiplexeurs 324 et 326, et des paramètres de configuration du circuit de rétroaction 328, soient stockés dans les emplacements mémoire 250 (figure 2). On peut ainsi sélectionner la provenance des signaux appliqués aux entrées de l'amplificateur 322 et les paramètres de configuration du circuit de rétroaction en phase d'utilisation. Cette sélection est de préférence choisie pour réaliser des fonctions correspondant à l'application.

Les entrées sélectionnées des multiplexeurs 324 et 326, et les paramètres du circuit de rétroaction 328, peuvent ainsi être différents en phase d'autodiagnostic et en phase d'utilisation. Ceci permet de choisir des tests de l'amplificateur au cours de l'autodiagnostic indépendamment des fonctions réalisées par l'amplificateur en utilisation.

Divers modes de réalisation et variantes ont été décrits. La portée de l'invention est définie par les revendications annexées.

## Revendications

1. Puce électronique comprenant :
un premier (140) et un deuxième (140A) plots de connexion d'entrée analogique ;
un plot de connexion de sortie (142) analogique ;
un circuit numérique (110) ;
un convertisseur analogique-numérique (132) reliant les premier et deuxième plots d'entrée au circuit numérique (110) ;
un convertisseur numérique-analogique (130) reliant le circuit numérique (110) au plot de sortie ;
un premier interrupteur (152) reliant le premier plot d'entrée (140) au plot de sortie (142) ;
un amplificateur (230) ayant une entrée reliée au premier plot d'entrée (140) et une sortie reliée au deuxième plot d'entrée (140A) ;
un deuxième interrupteur (210) reliant une entrée de l'amplificateur (230) au convertisseur analogique-numérique (132) ; et
un troisième interrupteur (210A) reliant une sortie de l'amplificateur (230) au convertisseur analogique-numérique (132), la puce étant configurée pour dans une phase d'autodiagnostic de la puce, commander les premier, deuxième et troisième interrupteurs pour tester sélectivement l'amplificateur avec le convertisseur analogique-numérique et avec le convertisseur numérique-analogique.

2. Puce selon la revendication 1, configurée pour que ledit premier interrupteur (150) soit toujours ouvert en dehors de la phase d'autodiagnostic.

3. Puce selon la revendication 1 ou 2, comprenant un ou plusieurs emplacements mémoire (220) de stockage de niveaux logiques de commande desdits interrupteurs (152 ; 210, 210A).

4. Puce selon la revendication 3, configurée pour protéger, par un mot de passe (P), l'écriture dans les emplacements mémoire (220).

5. Puce selon la revendication 4, dans laquelle les premiers emplacements (220) sont configurés pour stocker en outre des niveaux logiques supplémentaires de commande des interrupteurs en phase d'autodiagnostic.

6. Procédé de conception d'une puce selon l'une quelconque des revendications 1 à 5, comprenant l'association de chacun desdits plots (140, 142) à un des interrupteurs (152B, 152A) dans un bloc de conception (310A, 310B) d'une bibliothèque de conception par ordinateur, les blocs de conception étant identiques pour lesdits plots.

7. Procédé selon la revendication 6, dans lequel les blocs de conception comprennent chacun une résistance (315) connectée au plot.

8. Procédé selon la revendication 6 ou 7, dans lequel le bloc de conception (310A, 310B) comprend plusieurs, de préférence trois, interrupteurs connectés au plot.

9. Procédé d'autodiagnostic d'une puce électronique comprenant des premier et deuxième plots d'entrée de signal analogique (140, 140A) ; un plot de sortie de signal analogique (142) ; un circuit numérique (110) ; un convertisseur analogique-numérique (132) reliant les premier et deuxième plots d'entrée au circuit numérique (110) ; un convertisseur numérique-analogique (130) reliant le circuit numérique (110) au plot de sortie ; un premier interrupteur (152) reliant le premier plot d'entrée (140) au plot de sortie (142) ; un amplificateur (230) ayant une entrée reliée au premier plot d'entrée (140) et une sortie reliée au deuxième plot d'entrée (140A) ; un deuxième interrupteur (210) reliant une entrée de l'amplificateur (230) au convertisseur analogique-numérique (132) ; et un troisième interrupteur (210A) reliant une sortie de l'amplificateur (230) au convertisseur analogique-numérique (132), le procédé comprenant :
la commande des premier, deuxième et troisième interrupteurs pour sélectivement tester l'amplificateur avec le convertisseur analogique-numérique et avec le convertisseur numérique-analogique, la commande comprenant la fermeture du premier interrupteur ;
l'utilisation du convertisseur numérique-analogique, la transmission d'un signal de test du plot de sortie analogique au premier plot d'entrée analogique par l'intermédiaire du premier interrupteur ; et
le test du signal de test en utilisant le convertisseur analogique-numérique, le plot de sortie analogique ou le premier plot d'entrée analogique n'étant relié à aucun autre plot de la puce.

10. Procédé selon la revendication 9, comprenant le diagnostic simultané du convertisseur numérique-analogique (130) et du convertisseur analogique-numérique (132).

11. Procédé selon la revendication 10, comprenant la réception, par le convertisseur analogique-numérique (132), d'un signal (162) généré par le convertisseur numérique-analogique (130) et transmis du plot de sortie au premier plot d'entrée par ledit premier interrupteur (150).

## Patentansprüche

1. Elektronischer Chip, der Folgendes aufweist:
ein erstes (140) und ein zweites (140A) Anschlusspad für analoge Eingänge;
ein Anschlusspad für analoge Ausgänge (142);
eine digitale Schaltung (110);
einen Analog-Digital-Wandler (132), der die ersten und zweiten Eingangspads mit der digitalen Schaltung (110) verbindet;
einen Digital-Analog-Wandler (130), der die digitale Schaltung (110) mit dem Ausgangspad verbindet;
einen ersten Schalter (152), der das erste Eingangspad (140) mit dem Ausgangspad (142) verbindet;
einen Verstärker (230) mit einem Eingang, der mit dem ersten Eingangspad (140) gekoppelt ist, und einem Ausgang, der mit dem zweiten Eingangspad (140A) gekoppelt ist;
einen zweiten Schalter (210), der einen Eingang des Verstärkers (230) mit dem Analog-Digital-Wandler (132) koppelt; und
einen dritten Schalter (210A), der einen Ausgang des Verstärkers (230) mit dem Analog-Digital-Wandler (132) koppelt, wobei der Chip konfiguriert ist zum Steuern, während einer Selbstdiagnosephase des Chips, der ersten, zweiten und dritten Schalter, um den Verstärker selektiv mit dem Analog-Digital-Wandler und dem Analog-Digital-Wandler zu testen.

2. Chip nach Anspruch 1, so konfiguriert ist, dass der erste Schalter (150) außerhalb der Selbstdiagnosephase immer offen ist.

3. Chip nach Anspruch 1 oder 2, der einen oder mehrere Speicherplätze (220) zum Speichern logischer Pegel zur Steuerung der Schalter (152; 210, 210A) aufweist.

4. Chip nach Anspruch 3, der konfiguriert ist zum Schützen, durch ein Passwort (P), des Schreibens in die Speicherplätze (220).

5. Chip nach Anspruch 4, wobei die ersten Speicherplätze (220) konfiguriert sind zum Speichern zusätzlicher Logikpegel zum Steuern zusätzlicher Schalter in der Selbstdiagnosephase.

6. Verfahren zum Entwerfen eines Chips nach einem der Ansprüche 1 bis 5, bei dem jedem der Pads (140, 142) einem der Schalter (152B, 152A) in einem Entwurfsblock (310A, 310B) einer Computerentwurfsbibliothek zugeordnet wird, wobei die Entwurfsblöcke für die Pads identisch sind.

7. Verfahren nach Anspruch 6, wobei die Designblöcke jeweils einen Widerstand (315) aufweisen, der mit dem Pad verbunden ist.

8. Verfahren nach Anspruch 6 oder 7, wobei der Designblock (310A, 310B) mehrere, vorzugsweise drei, mit dem Pad verbundene Schalter aufweist.

9. Verfahren zur Selbstdiagnose eines elektronischen Chips, mit einem ersten und einem zweiten Analogsignal-Eingangspad (140, 140A) ; einem Analogsignal-Ausgangspad (142) ; einer digitalen Schaltung (110); einem Analog-Digital-Wandler (132), der das erste und das zweite Eingangspad mit der digitalen Schaltung (110) verbindet; einem Digital-Analog-Wandler (130), der die digitale Schaltung (110) mit dem Ausgangspad verbindet; einem ersten Schalter (152), der das erste Eingangspad (140) mit dem Ausgangspad (142) verbindet; einem Verstärker (230) mit einem Eingang, der mit dem ersten Eingangspad (140) gekoppelt ist, und einem Ausgang, der mit dem zweiten Eingangspad (140A) gekoppelt ist; einem zweiten Schalter (210), der einen Eingang des Verstärkers (230) mit dem Analog-Digital-Wandler (132) koppelt; und einem dritten Schalter (210A), der einen Ausgang des Verstärkers (230) mit dem Analog-Digital-Wandler (132) koppelt, wobei das Verfahren Folgendes aufweist:
Steuern des ersten, zweiten und dritten Schalters zum selektiven Testen des Verstärkers mit dem Analog-Digital-Wandler und mit dem Digital-Analog-Wandler, wobei das Steuern das Schließen des ersten Schalters aufweist;
unter Verwendung des Digital-Analog-Wandlers, Senden eines Testsignals vom Analog-Ausgangspad zum ersten Analog-Eingangspad über den ersten Schalter; und
Testen des Testsignals unter Verwendung des Analog-Digital-Wandlers, wobei das Analog-Ausgangspad oder das erste Analog-Eingangspad mit keinem anderen Pad des Chips gekoppelt ist.

10. Verfahren nach Anspruch 9, aufweisend die gleichzeitige Diagnose des Digital-Analog-Wandlers (130) und des Analog-Digital-Wandlers (132).

11. Verfahren nach Anspruch 10, aufweisend das Empfangen eines Signals (162) durch den Analog-Digital-Wandler (132), das durch den Digital-Analog-Wandler (130) erzeugt und über den ersten Schalter (150) vom Ausgangspad zum ersten Eingangspad gesendet wurde.

## Claims

1. Electronic chip comprising:
a first (140) and a second (140A) analog input connection pads;
an analog output connection pad (142);
a digital circuit (110);
an analog-to-digital converter (132) coupling the first and second input pads with the digital circuit (110);
a digital-to-analog converter (130) coupling the digital circuit (110) with the output pad;
a first switch (152) coupling the first input pad (140) with the output pad (142);
an amplifier (230) having an input coupled with the first input pad (140) and an output coupled with the second input pad (140A);
a second switch (210) coupling an input of the amplifier (230) with the analog-to-digital converter (132); and
a third switch (210A) coupling an output of the amplifier (230) with the analog-to-digital converter (132), the chip being configured to, during a self-diagnosis phase of the chip, control the first, second, and third switches to selectively test the amplifier with the analog-to-digital converter and the digital-to-analog converter.

2. Chip according to claim 1, configured so as the first switch (150) is always open outside of the self-diagnosis phase.

3. Chip according to claim 1 or 2, comprising one or more memory locations (220) for storing logic levels for controlling said switches (152; 210, 210A).

4. Chip according to claim 3, configured to protect, by a password (P), the writing in the memory locations (220).

5. Chip according to claim 4, wherein the first locations (220) are configured to further store additional logic levels for controlling additional switches in the self-diagnosis phase.

6. Method of designing a chip according to any one of claims 1 to 5, comprising associating each of said pads (140, 142) with one of the switches (152B, 152A) in a design block (310A, 310B) of a computer design library, the design blocks being identical for said pads.

7. Method according to claim 6, wherein the design blocks comprise each a resistor (315) connected to the pad.

8. Method according to claim 6 or 7, wherein the design block (310A, 310B) comprises several, preferably three, switches connected to the pad.

9. Method for self-diagnosis of an electronic chip, comprising first and second analog-signal input pads (140, 140A); an analog-signal output pad (142); a digital circuit (110); an analog-to-digital converter (132) coupling the first and second input pads with the digital circuit (110); a digital-to-analog converter (130) coupling the digital circuit (110) with the output pad; a first switch (152) coupling the first input pad (140) with the output pad (142); an amplifier (230) having an input coupled with the first input pad (140) and an output coupled with the second input pad (140A); a second switch (210) coupling an input of the amplifier (230) with the analog-to-digital converter (132); and a third switch (210A) coupling an output of the amplifier (230) with the analog-to-digital converter (132), the method comprising:
controlling the first, second, and third switches to selectively test the amplifier with the analog-to-digital converter and with the digital-to-analog converter, controlling comprising closing the first switch;
using the digital-to-analog converter, transmitting the test signal from the analog output pad to the first switch via the first switch; and
testing the test signal using the analog-to-digital converter, the analog output pad or the first analog input pad being coupled with no other pad of the chip.

10. Method according to claim 9, comprising simultaneously diagnosing the digital-to-analog converter (130) and the analog-to-digital converter (132).

11. Method according to claim 10, comprising receiving, by the analog-to-digital converter (132), a signal (162) generated by the digital-to-analog converter (130), and transmitted from the output pad to the first input pad by said first switch (150).
